# EUROPEAN PATENT APPLICATION

(11) **EP 3 764 117 A1**
(43) Date of publication of application: **13.01.2021**
(21) Application number: 19185133.6
(22) Date of filing: 09.07.2019
(51) Int. Cl.: G01R 33/48

(54) **ENHANCED 3D RADIAL MR IMAGING**

(71) Applicant: Koninklijke Philips N.V., 5656 AG Eindhoven (NL)
(72) Inventor: EGGERS, Holger, 5656 AE Eindhoven (NL)
(74) Representative: de Haan, Poul Erik

(57) **Abstract**

The invention relates to a method of MR imaging of an object (10) positioned in an examination volume of a MR device (1). It is an object of the invention to provide an arrangement and ordering of the radial k-space spokes for 3D radial imaging that achieves an efficient and uniform k-space coverage. The method of the invention comprises the steps of:- specifying a set of radial k-space spokes to cover a spherical k-space volume, which set is subdivided into a number of subsets, wherein the end points of the spokes of each subset are distributed along a trajectory forming a spherical spiral in k-space with subsampling along the trajectory and wherein the trajectories of the different subsets are rotated relative to each other about an axis passing through the k-space origin,
- generating MR signals by subjecting the object (10) to an imaging sequence, wherein the MR signals are acquired to sample the spokes of one of the subsets,
- executing step b) for each of the subsets until the full set of spokes is sampled,
- reconstructing an MR image from the acquired MR signals.

Moreover, the invention relates to a MR device and to a computer program for a MR device.

## Description

### FIELD OF THE INVENTION

The invention relates to the field of magnetic resonance (MR) imaging. It concerns a method of MR imaging involving a three-dimensional (3D) radial sampling of k-space. The invention also relates to a MR device and to a computer program to be run on a MR device.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation, and are usually not invasive.

According to the MR method in general, the body of the patient to be examined is arranged in a strong, uniform magnetic field (Bo field) whose direction at the same time defines an axis (normally the z-axis) of the coordinate system on which the measurement is based. The magnetic field produces different energy levels for the individual nuclear magnetic spins in dependence on the magnetic field strength which can be excited (magnetic resonance) by application of an alternating electromagnetic field (RF field, also referred to as B₁ field) of defined frequency (Larmor frequency, or MR frequency). From a macroscopic point of view the distribution of the individual nuclear magnetic spins produces an overall magnetization which can be deflected out of the state of equilibrium by application of an electromagnetic pulse of appropriate frequency (RF pulse) while the magnetic field extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied RF pulse. In case of a flip angle of 90°, the nuclear magnetic spins are deflected from the z-axis to the transverse plane.

After termination of the RF pulse, the magnetization relaxes back to the original state of equilibrium, in which the magnetization in the z direction is built up again with a first time constant T₁ (spin-lattice or longitudinal relaxation time), and the magnetization in the direction perpendicular to the z direction relaxes with a second time constant T₂ (spin-spin or transverse relaxation time). The variation of the magnetization can be detected by means of one or more receiving RF coils which are arranged and oriented within an examination volume of the MR device in such a manner that the variation of the magnetization is measured in the direction perpendicular to the z-axis. The decay of the transverse magnetization is accompanied, after application of, for example, an RF pulse with a flip angle of 90°, by a transition of the nuclear magnetic spins (induced by local magnetic field inhomogeneity) from an ordered state with the same phase to a state in which all phase angles are uniformly distributed (dephasing). The dephasing can be compensated by means of a refocusing RF pulse (for example an RF pulse with a flip angle of 180°). This produces an echo signal (spin echo) in the receiving coils.

In order to realize spatial resolution in the body of the patient, linear magnetic field gradients extending along the three main axes are superposed on the uniform magnetic field, leading to a linear spatial dependency of the nuclear magnetic spins' resonance frequency. The signal picked up in the receiving coils then contains components of different frequencies which can be associated with different locations in the body of the patient. The MR signal received via the RF coils corresponds to the spatial frequency domain, which is called k-space. The data is usually collected in k-space along multiple lines acquired with different phase encoding. Each line is digitized by collecting a number of samples. A set of k-space data is converted to a MR image by means of Fourier transformation or other appropriate reconstruction algorithms.

In 3D radial MR imaging, a number of k-space lines are acquired that constitute projections through the imaged object at different orientations, transformed to the spatial frequency domain. These particular k-space lines are also referred to as spokes. The frequency encoding involves in this case the simultaneous application of linear magnetic field gradients along all three coordinate axes with varying amplitudes to produce the required rotational pattern in k-space to fully cover a spherical volume in k-space according to the desired field of view (FOV) and spatial resolution. The spokes are defined by polar and azimuthal rotation angles that are incremented independently during the acquisition. Their end points are distributed on the surface of the spherical k-space volume. Due to the visual similarity of the arrangement of the spokes in k-space with the corresponding child's toy, 3D radial MR imaging is sometimes also referred to as Koosh ball imaging.

In practice, the set of spokes that needs to be sampled to fully cover the spherical k-space volume can be subdivided into a number of subsets ("interleaves") that are acquired sequentially in a corresponding number of repetitions ("shots") of the used imaging sequence.

The acquired k-space data is typically not reconstructed using filtered back projection but is gridded onto a Cartesian k-space grid and then transformed to image space.

Different techniques have been proposed to arrange and order the spokes in k-space to achieve an efficient and uniform coverage of the spherical k-space volume. Ideally, the following three requirements are met:
1. Uniform distribution of the end points of the spokes on the surface of the spherical k-space volume,
2. uniform distribution of the end points of the spokes of each subset on the surface of the spherical k-space volume,
3. minimal distance between the end points of subsequently sampled spokes. The first requirement ensures minimal acquisition time and a maximum signal-to-noise ratio (SNR). The second requirement reduces susceptibility to undersampling, provides a high motion robustness and enables motion compensation. The third requirement reduces eddy currents and, thus, image artifacts as well as acoustic noise during the acquisition.

Typically, trajectories are specified that determine both the position of the end points of the spokes on the surface of the sphere and the temporal order in which the spokes are sampled. Various trajectories have been proposed for 3D radial MR imaging over the last years as attempts to satisfy the three requirements above.

A nearly uniform distribution of the end points of the spokes on the surface of the sphere and a minimal distance between consecutive end points is achieved by placing the end points along a spherical spiral trajectory traversing the surface of the sphere from one pole to the equator or to the other pole (see Wong et al., Magn. Reson. Med., 1994, vol. 32, p. 778-784).

In another approach, a nearly uniform distribution of the end points of the spokes of a number of subsets on the surface of the sphere is obtained by incrementing the polar and azimuthal rotation angles of the spokes according to the golden angle ratio (see Doneva et al., Proc. ISMRM 2008, p. 336).

A further approach is known as "spiral phyllotaxis" (see Piccini et al., Magn. Reson. Med., 2011, vol. 66, p. 1049-1056). It is based on the spiral phyllotaxis known in botany as a particular arrangement of leaves on a stem. It is claimed to combine a uniform distribution of the end points of the spokes on the surface of the sphere and a minimal distance between the end points of subsequently sampled spokes.

However, all of these known approaches to 3D radial MR imaging fail to meet at least one of the three requirements above. The spherical spiral trajectory does not provide a uniform distribution of the end points of the spokes of each subset on the surface of the spherical k-space volume. The golden angle approach leads to a large distance between the end points of consecutively sampled spokes, as does the spherical spiral trajectory in combination with subsampling. The spiral phyllotaxis trajectory does not achieve a uniform distribution of the end points of the spokes of each subset on the surface of the spherical k-space volume either.

### SUMMARY OF THE INVENTION

From the foregoing it is readily appreciated that there is a need for an improved method of 3D radial MR imaging. It is an object of the invention to provide an arrangement and ordering of the radial k-space spokes that achieves an efficient and uniform k-space coverage and that meets all three requirements mentioned above.

In accordance with the invention, a method of MR imaging of an object positioned in the examination volume of a MR device is disclosed. The method of the invention comprises the steps of:
- specifying a set of radial k-space spokes to cover a spherical k-space volume, which set is subdivided into a number of subsets, wherein
   - the end points of the spokes of each subset are distributed along a trajectory forming a spherical spiral in k-space with subsampling along the trajectory and
   - the trajectories of the different subsets are rotated relative to each other about an axis passing through the k-space origin,
- generating MR signals by subjecting the object (10) to an imaging sequence, wherein the MR signals are acquired to sample the spokes of one of the subsets,
- executing step b) for each of the subsets until the full set of spokes is sampled, and
- reconstructing an MR image from the acquired MR signals.

According to the invention, a set of radial k-space spokes is initially specified to cover a spherical k-space volume (step a). The spherical k-space volume is determined by the desired field of view (FOV). The radial k-space spokes either start in the k-space origin and end on the surface of the sphere, or they start and end on the surface of the sphere and pass through the k-space origin The minimum density of the end points of the spokes on the surface of the sphere is determined by the desired spatial resolution of the MR image to be finally reconstructed. In case an anisotropic spatial resolution is desired the spherical k-space volume generalizes to an ellipsoidal k-space volume.

The invention describes a modified spherical spiral trajectory that meets all three requirements above. According to the invention, a simultaneous subdivision into subsets, whereby the end points of the spokes of each subset are distributed along a spherical spiral trajectory, with subsampling along the spherical spiral trajectory, is applied to attain in particular a uniform distribution of the end points of the spokes of each subset on the surface of the spherical k-space volume. Hence, the invention contributes to minimizing acquisition time, maximizing SNR, decreasing susceptibility to undersampling, increasing robustness to motion, and/or reducing eddy currents and acoustic noise.

The trajectories of the different subsets are rotated relative to each other about an axis passing through the k-space origin. The number of subsets and the rotation angles are in principle selected to fully cover the spherical k-space volume.

Preferably, each trajectory reaches from one pole to the other pole of the spherical k-space volume, and each trajectory starts at the pole the preceding trajectory ended at. Alternatively, it may reach from one pole to the equator only.

In the next steps (step b and c), the subsets are acquired one after another until the full set of spokes is sampled, wherein the spokes are sampled in the sequence in which they are aligned along each trajectory.

Finally (step d), an MR image is reconstructed in the conventional fashion from the full set of spokes.

In a preferred embodiment, the end points of the spokes are equidistantly distributed along each trajectory, wherein the distance between adjacent end points of the spokes along each trajectory equals or approximates the distance between the windings of the spiral such that the spokes of each subset are uniformly distributed over the spherical k-space volume.

The invention enables adjustment of the subsampling by choosing the distance between adjacent end points of the spokes along the trajectory. In particular, this distance can be matched to the distance of the windings such that an overall uniform distribution of the end points of each subset on the surface of the sphere is obtained.

The trajectories of subsequently sampled subsets are preferably rotated relative to each other by the golden angle. In this way, subsequently sampled subsets always add complementary information while filling the largest gaps within the set of previously sampled k-space spokes. Alternatively, the small golden angle, any of the tiny golden angles, or fractions thereof may be used.

In another preferred embodiment, the imaging sequence is a zero echo time (ZTE) imaging sequence, in which a readout magnetic field gradient is set before excitation of magnetic resonance with a high-bandwidth and thus short, hard RF pulse. In this way, frequency encoding begins instantaneously upon excitation of magnetic resonance. The acquisition of the free induction decay (FID) signal along a radial k-space spoke starts immediately after the RF pulse resulting in an effectively echo time (TE) of zero. After the acquisition, only minimal time is required for setting of the next readout magnetic field gradient before the next RF pulse can be applied, thus enabling very short repetition times (TRs). The readout magnetic field gradient's direction is incrementally varied from repetition to repetition until the spherical volume in k-space is sampled to the required extent, with each of the acquired spokes starting in the k-space origin. Without the need for switching off the readout magnetic field gradient between TRs, ZTE imaging can be performed virtually silently. Similarly, an ultra-short echo time (UTE) imaging sequence may be used for the acquisition of the FID signal.

In yet another preferred embodiment, the imaging sequence is a spoiled or refocused (balanced) gradient echo imaging sequence, wherein each of the subsets is sampled as a sequence of gradient echo signals.

In yet another preferred embodiment, the imaging sequence is a combination of a ZTE or UTE imaging sequence and of a spoiled or refocused (balanced) gradient echo imaging sequence, wherein each of the subsets is sampled as a sequence of FID and gradient echo signals.

The invention can advantageously be combined with a multi-echo acquisition, wherein the total set of spokes required to reconstruct the MR image is divided into a number of "shots", i.e. RF excitations followed by a number of refocusing magnetic field gradients or refocusing RF pulses to generate a train of gradient echoes, with each echo corresponding to one spoke and each shot corresponding to one subset.

The method of the invention described thus far can be carried out by means of a MR device including at least one main magnet coil for generating a uniform steady magnetic field within an examination volume, a number of gradient coils for generating switched magnetic field gradients in different spatial directions within the examination volume, at least one RF coil for generating RF pulses within the examination volume and/or for receiving MR signals from a body of a patient positioned in the examination volume, a control unit for controlling the temporal succession of RF pulses and switched magnetic field gradients, and a reconstruction unit. The method of the invention is preferably implemented by a corresponding programming of the control unit and/or the reconstruction unit of the MR device.

The method of the invention can be advantageously carried out by most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 schematically shows a MR device for carrying out the method of the invention;
Fig. 2 illustrates the conventional arrangement of the end points of the spokes of one subset on a spherical spiral trajectory;
Fig. 3 illustrates the conventional arrangement of the end points of the spokes of one subset on a spiral phyllotaxis trajectory;
Fig. 4 illustrates the arrangement of the end points of the spokes of one subset according to the invention.

### DETAILED DESCRIPTION OF THE EMBODIMENTS

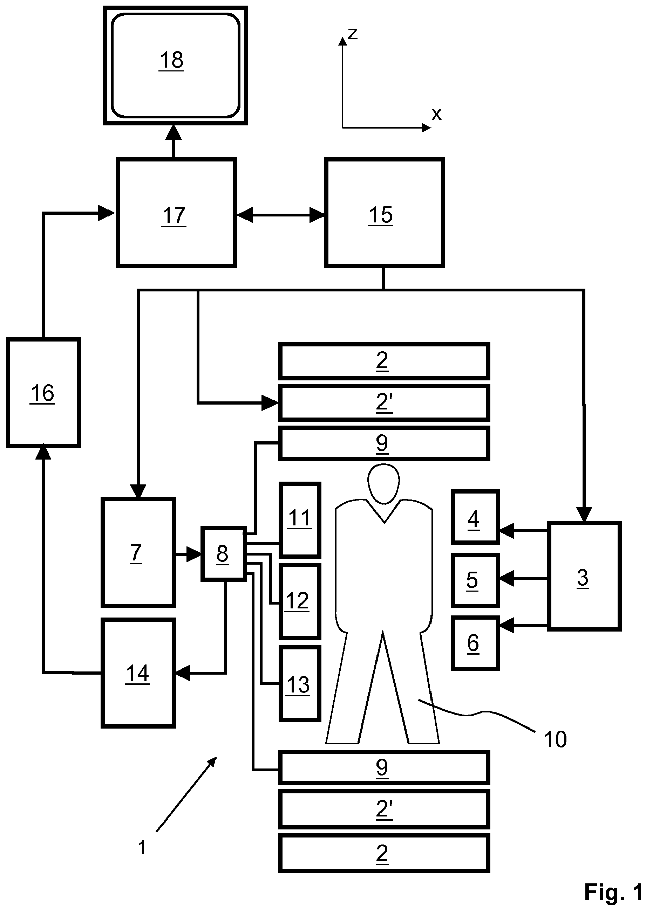

With reference to Fig. 1, a MR device 1 which can be used for carrying out the method of the invention is shown. The device comprises superconducting or resistive main magnet coils 2 such that a substantially uniform, temporally constant main magnetic field Bo is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to excite, invert, or saturate nuclear magnetic spins, to induce, refocus, and manipulate magnetic resonance, to spatially and otherwise encode magnetic resonance, and the like to perform MR imaging.

More specifically, a gradient pulse amplifier 3 applies current pulses to selected ones of whole-body gradient coils 4, 5 and 6 along x, y and z-axes of the examination volume. A digital RF transmitter 7 transmits RF pulses, via a send/receive switch 8, to a body RF coil 9 to transmit RF pulses into the examination volume. A typical MR imaging sequence is composed of RF pulses of short duration which, taken together with any applied magnetic field gradients, achieve a selected manipulation of magnetic resonance, including the selection of a portion of a body 10 positioned in the examination volume. The MR signals are also picked up by the body RF coil 9.

For generation of MR images of a limited region of the body 10 by means of parallel imaging, a set of local array RF coils 11, 12, 13 is placed contiguous to the region to be imaged. The array coils 11, 12, 13 can be used to receive MR signals induced by RF transmissions with the body RF coil.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the current flow through the shimming coils 2' as well as the gradient pulse amplifier 3 and the RF transmitter 7 to generate, e.g., a ZTE or a refocused gradient echo imaging sequence according to the invention. The receiver 14 receives the MR signal from the individual radial k-space spokes after the RF excitation pulses in rapid succession. A data acquisition system 16 performs analog-to-digital conversion of the received MR signal and converts it to a digital format suitable for further processing. In modern MR devices the data acquisition system 16 is a separate computer which is specialized in the acquisition of raw image data.

Ultimately, the digital raw data is reconstructed into an image representation by a reconstruction processor 17 which applies an appropriate reconstruction algorithm. The MR image represents a three-dimensional volume. The image is then stored in an image memory where it may be accessed for converting projections or other portions of the image representation into an appropriate format for visualization, for example via a video monitor 18 which provides a human-readable display of the resultant MR image.

According to the invention, 3D radial MR imaging is performed, wherein a number of radial k-space spokes is acquired to cover a spherical volume in k-space. The radial k-space spokes are defined by polar and azimuthal rotation angles that are incremented independently during the acquisition, wherein the end points of the radial k-space spokes are distributed on the surface of the spherical k-space volume. The acquired MR signal is finally gridded onto a Cartesian k-space grid and then reconstructed into an MR image via Fourier transformation.

Trajectories are specified that determine both the positions of the end points of the spokes on the sphere and the temporal order in which the spokes are sampled.

It is essential to arrange and order the spokes in k-space and time properly to achieve a uniform and efficient k-space coverage.

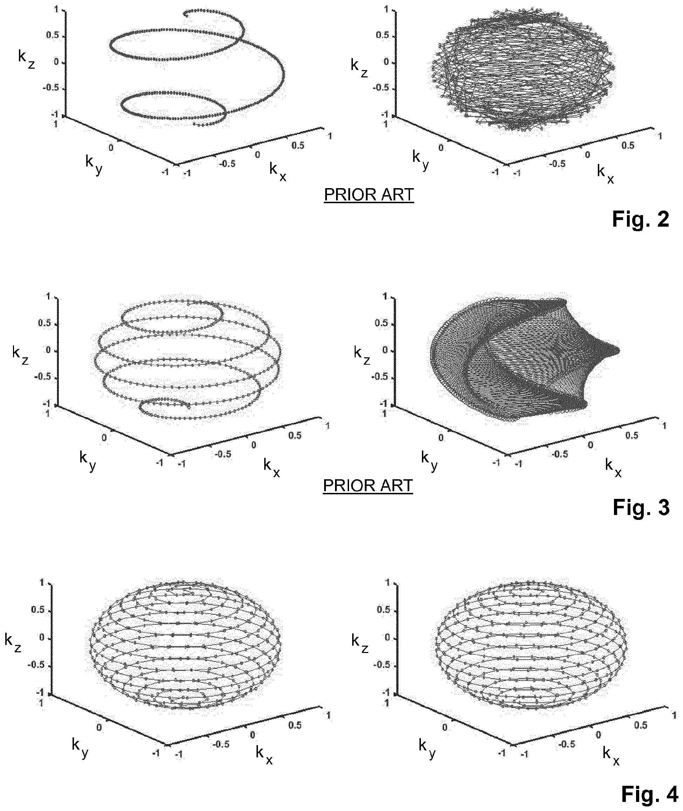

A nearly uniform distribution of the end points of the spokes on the surface of the sphere and a minimal distance between consecutively sampled end points are achieved by aligning the end points along a spherical spiral trajectory traversing the surface of the sphere from one pole to the other pole. This is illustrated in Fig.2. The two k-space diagrams show the end points of the spokes of one subset each, following a spherical spiral trajectory, wherein the end points of consecutively sampled spokes are interconnected by a straight line. In the depicted embodiment, the full set of spokes covering the spherical k-space volume is subdivided into 36 subsets. The subset shown in the left diagram comprises all spokes of 1 out of 36 trajectories. To fully cover the spherical k-space volume, the shown trajectory is rotated around the k_{z}-axis. This subdivision into subsets does obviously not provide a uniform distribution of the end points on the surface of the sphere. The distance between the end points along the trajectory is much smaller than the distance of the windings of the spiral. The subset shown in the right diagram comprises every 36th spoke of 1 out of 1 trajectory. To fully cover the spherical k-space volume, the shown trajectory is basically kept, as is the selection of every 36^{th} spoke, but the selection of the first spoke is changed. This subsampling along the trajectory leads to a large distance between the end points along the trajectory.

Another way of specifying the distribution of the end points of the spokes on the surface of the sphere is based on spiral phyllotaxis. As shown in Fig.3, the spiral phyllotaxis trajectory achieves a better, but still far from uniform distribution of the end points of the spokes on the surface of the sphere. In the left diagram, the end points of the spokes of 1 out of 34 trajectories are plotted. Choosing a Fibonacci number, such as 34, for the number of subsets, leads to a more uniform distribution of the end points of the spokes on the surface of the sphere than in Fig.2. For other numbers, such as 36, however, the distance between the end points of consecutively sampled spokes is again very large, as seen in the right diagram.

To obtain a uniform distribution of the end points of the spokes, for both the entire set and each subset, and a minimal distance between the end points of consecutively sampled spokes, the invention proposes a modified spherical spiral trajectory. In addition to the subdivision into subsets, in which the trajectories are rotated relative to each other, a matching subsampling along the trajectories is introduced. A uniform distribution of the end points of the spokes is thus achieved for each subset, as evident from Fig.4. While the left diagram shows the end points of the spokes of 1 out of 34 subsets, the right diagram shows those of 1 out of 36 subsets. By choosing the number of subsets equal to the subsampling factor along the trajectories, the distance between the end points of consecutively sampled spokes along the trajectory approximates the distance between adjacent windings of the spiral. Notably, the overall reduction factor does not have to be an integer. Thus, the choice of the overall acceleration is much more flexible with the proposed trajectory than with the spiral phyllotaxis trajectory described above.

As with the spherical spiral trajectory and the spiral phyllotaxis trajectory, the choice of the rotation angles between the spiral trajectories of the different subsets is unrestricted in the method of the invention, since the distance between end points vanishes at the poles of the sphere.. Therefore, in particular a rotation according to the golden angle is still possible.

## Claims

1. Method of MR imaging of an object (10) positioned in an examination volume of a MR device (1), the method comprising the steps of:- specifying a set of radial k-space spokes to cover a spherical k-space volume, which set is subdivided into a number of subsets, wherein
- - the end points of the spokes of each subset are distributed along a trajectory forming a spherical spiral in k-space with subsampling along the trajectory and
- - the trajectories of the different subsets are rotated relative to each other about an axis passing through the k-space origin,
- generating MR signals by subjecting the object (10) to an imaging sequence, wherein the MR signals are acquired to sample the spokes of one of the subsets,
- executing step b) for each of the subsets until the full set of spokes is sampled, and
- reconstructing an MR image from the acquired MR signals.

2. Method of claim 1, wherein the distance between adjacent end points of the spokes along each trajectory equals or approximates the distance between the windings of the spiral such that the spokes of each subset are uniformly distributed over the spherical k-space volume.

3. Method of claim 1 or 2, wherein the trajectories of subsequently sampled subsets are rotated relative to each other by the golden angle, the small golden angle, any of the tiny golden angles, or fractions thereof.

4. Method of any one of claims 1-3, wherein the imaging sequence is a zero echo time or ultra-short echo time imaging sequence, wherein each of the subsets is sampled as a sequence of free induction decay signals.

5. Method of any one of claims 1-3, wherein the imaging sequence is a spoiled or refocused gradient echo imaging sequence, wherein each of the subsets is sampled as a sequence of gradient echo signals.

6. Method of any one of claims 1-3, wherein the imaging sequence is a combination of a zero echo time or ultra-short echo time imaging sequence and of a spoiled or refocused gradient echo imaging sequence, wherein each of the subsets is sampled as a sequence of free induction decay signals and gradient echo signals.

7. Method of any one of claims 1-6, wherein each trajectory reaches from one pole to the other pole of the spherical k-space volume.

8. Method of any one of claims 1-7, wherein each trajectory starts at the pole the preceding trajectory ended at.

9. Method of any one of claims 1-8, wherein the spokes are sampled in the sequence in which they are aligned along each trajectory.

10. MR device comprising at least one main magnet coil (2) for generating a uniform, static magnetic field within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17), wherein the MR device (1) is arranged to perform the following steps:
- specifying a set of radial k-space spokes to cover a spherical k-space volume, which set is subdivided into a number of subsets, wherein
- the end points of the spokes of each subset are distributed along a trajectory forming a spherical spiral in k-space with subsampling along the trajectory and
- the trajectories of the different subsets are rotated relative to each other about an axis passing through the k-space origin,
- generating MR signals by subjecting the object (10) to an imaging sequence, wherein the MR signals are acquired to sample the spokes of one of the subsets,
- executing step b) for each of the subsets until the full set of spokes is sampled,
- reconstructing an MR image from the acquired MR signals.

11. Computer program to be run on a MR device, which computer program comprises instructions for:
- specifying a set of radial k-space spokes to cover a spherical k-space volume, which set is subdivided into a number of subsets, wherein
- the end points of the spokes of each subset are distributed along a trajectory forming a spherical spiral in k-space with subsampling along the trajectory and - the trajectories of the different subsets are rotated relative to each other about an axis passing through the k-space origin,
- generating an imaging sequence and acquiring MR signals to sample the spokes of one of the subsets,
- executing step b) for each of the subsets until the full set of spokes is sampled,
- reconstructing an MR image from the acquired MR signals.
